# EUROPÄISCHE PATENTANMELDUNG

(11) **EP 2 725 374 A2**
(43) Veröffentlichungstag der Anmeldung: **30.04.2014**
(21) Anmeldenummer: 13189332.3
(22) Anmeldetag: 18.10.2013
(51) Int. Cl.: G01R 33/00

(54) **Messanordnung**

(30) Priorität: 24.10.2012 DE 102012110117
(71) Anmelder: Listec GmbH, 84424 Isen (DE)
(72) Erfinder: Hirschenauer, Nikolaus, 85435 Erding (DE)
(74) Vertreter: Strasser, Wolfgang

(57) **Zusammenfassung**

Bei einer Messanordnung (1) mit mehreren Messeinheiten (4), die durch ein Kabel (5) miteinander und mit einer Zentrale (2) verbunden sind und jeweils einen Magnetfeldsensor (12) umfassen, der ein elektrisches Messsignal erzeugt, das seinen Wert in Abhängigkeit von einem äußeren Magnetfeld ändert, werden die Messeinheiten von der Zentrale mit elektrischer Energie versorgt und besitzen jeweils eine Adresse, sodass die Zentrale zyklisch die momentanen Messwerte der Magnetfeldsensoren einzeln nacheinander abfragen kann. Die Messanordnung ist dadurch gekennzeichnet, dass jeder der Magnetfeldsensoren auf einem von dem Kabel dicht umschlossenen Träger (9) montiert ist, dass die Träger mit gegenseitigen Abständen auf einer im Kabel verlaufenden, zur Zentrale führenden, mehradrigen, keine Unterbrechungen aufweisenden Busleitung (7) montiert sind, die zur Energieversorgung der Messeinheiten und zur Datenübermittlung dient, und dass jede der Messeinheiten einen eigenen Mikroprozessor (11) mit Speichereinheit umfasst, der mit dem zugehörigen Magnetfeldsensor verbunden ist und zumindest eine Vorverarbeitung des Messsignals des Magnetfeldsensors ausführen kann.

## Beschreibung

Die Erfindung betrifft eine Messanordnung der im Oberbegriff von Anspruch 1 genannten Art.

Derartige Messanordnungen sind beispielsweise aus der DE 36 22 800 A1 bekannt. Sie umfassen im Allgemeinen eine Vielzahl von Messeinheiten, die linear in einem Kabel angeordnet sind, das eines Busleitung umfasst, welche die Messeinheiten elektrisch, d.h. zur Energievorsorgung und zur Datenübermittlung, mit einer Zentrale verbindet.

Ein typischer Anwendungsfall für Messanordnungen, deren Messeinheiten temperaturempfindliche Sensoren umfassen, ist die die Überwachung von Tunnels oder von Förderbändern und dergleichen, um Überhitzungen bzw. Brände nicht nur schnell feststellen, sondern auch möglichst genau orten zu können. Zu diesem Zweck ist jeder der Messeinheiten eine individuelle Adresse zugeordnet und die Zentrale fragt über die Busleitung zyklisch die momentanen Messwerte ab, die aufgrund der Adressierung der jeweiligen Messeinheit genau zugeordnet werden können.

Die Kabellängen können zwischen einigen hundert Metern und einigen Kilometern betragen und die Abstände der Messeinheiten innerhalb des Kabels, die im Prinzip frei wählbar sind, können in einem Bereich von einigen Zentimetern bis einigen Metern liegen.

Solche Messanordnungen, deren Messeinheiten mit temperaturempfindlichen Sensoren ausgerüstet sind, haben sich seit vielen Jahren bewährt. In der DE 36 22 800 A1 wird darauf hingewiesen, dass die Kabel der dort beschriebenen Systeme auch mit Sensoren ausgerüstet werden können, die auf die Änderung anderer Umgebungsparameter, beispielsweise eines Magnetfeldes reagieren.

Da Magnetfelsmessungen unter Umständen unter sehr rauen Umgebungsbedingungen durchgeführt werden müssen, liegt der Erfindung die Aufgabe zugrunde, die bekannte Messanordnung so weiterzubilden, dass sie auch bei schwierigeren Einsatzbedingungen und in aggressiven Umgebungen verwendet werden kann, bei denen die Belastungen durch Umwelteinflüsse weit über diejenigen hinausgehen, wie sie im Inneren von Tunnels und dergleichen auftreten.

Zur Lösung dieser Aufgabe sieht die Erfindung die im Anspruch 1 zusammengefassten Merkmale vor.

Durch die absolut dichte Kapselung der Messeinheiten mit ihren Magnetfeldsensoren und Mikroprozessoren in dem sie vollständig und dicht umschließenden Kabel, ist es möglich, derartige Kabel in Umgebungen zu verlegen, in welchen sie sehr hohen Belastungen ausgesetzt sind, beispielsweise auf oder dicht unter der Fahrbahndecke von Straßen oder Parkplätzen.

Dadurch, dass auf dem Träger einer jeden Messeinheit nicht nur der eigentliche Magnetsensor sondern auch ein diesem Sensor zugeordneter Mikroprozessor mit Speicherbaustein vorgesehen ist, wird einerseits eine Kommunikation über größere Kabellängen ermöglicht und können andererseits bestimmte Aufgaben dezentral direkt an der jeweiligen Messeinheit erledigt werden.

Letzteres kann beispielsweise eine Kommunikation mit den Mikroprozessoren der im Kabel benachbarten Messeinheiten und/oder eine Zeitenmessung zwischen zwei Magnetfeldänderungen sein.

Ein besonderer Vorteil ist darin zu sehen, dass die Taktfrequenzen, mit denen die Übertragung auf der Busleitung durchgeführt wird, nicht genau so hoch oder gar höheren sein müssen, wie die Taktfrequenzen die für die Mikroprozessoren verwendet werden.

Bei einer besonders bevorzugten Ausführungsform kommen Magnetfelddetektoren zum Einsatz, die auf das Erdmagnetfeld bzw. dessen lokale Veränderungen ansprechen. Letztere treten beispielsweise dann auf, wenn ein Körper, der eine ferromagnetische Masse umfasst, in der Nähe eines solchen Magnetfeldsensors positioniert und/oder über diesen hinweg bewegt wird.

Bei einem besonders bevorzugten Anwendungsfall handelt es sich bei diesen Körpern um Fahrzeuge, deren ferromagnetischen Massen immer groß genug sind, um die von ihnen bewirkten Änderungen des Erdmagnetfeldes mit Hilfe eines geeigneten Sensors erfassen zu können, wenn dieser in oder knapp unterhalb der Oberfläche verlegt ist, auf der sich diese Fahrzeuge bewegen.

Bei den Fahrzeugen kann es sich sowohl um Schienenfahrzeuge aber insbesondere auch um Straßenfahrzeuge handeln.

Im letztgenannten Fall kann eine erfindungsgemäße Messanordnung beispielsweise zur Überwachung von Parkplätzen eingesetzt werden. Zu diesem Zweck wird das Kabel mäanderförmig so unter den zu überwachenden Parkfläche verlegt, dass sich im Bereich eines jeden Abstellplatzes wenigstens ein, vorzugsweise aber mehrere Sensoren befinden, durch deren Abfrage dann erkannt werden kann, ob auf dem betreffenden Stellplatz ein Fahrzeug abgestellt ist oder nicht. Insbesondere dann, wenn pro Stellplatz mehrere Sensoren vorgesehen sind, lässt sich auch dann die tatsächliche Belegung exakt erkennen, wenn unterschiedlich große Fahrzeuge geparkt sind und/oder Fahrzeuge so abgestellt wurden, dass sie sich sehr nahe an der Grenze von zwei benachbarten Abstellplätzen befinden oder diese sogar überdecken.

Eine andere Möglichkeit besteht darin, das Kabel einer erfindungsgemäßen Messanordnung in der Fahrbahn oder auf der Fahrbahnoberfläche von Straßen bzw. Kreuzungen zu verlegen, um die Verkehrsdichte zu ermitteln, z.B. über eine bestimmte Linie hinweg fahrende Fahrzeuge zu zählen und/oder deren Geschwindigkeit zu messen. Weiterhin ist es möglich, mit einem erfindungsgemäßen Messkabel Falschfahrer zu erkennen, die einen Straßenbereich entgegen einer vorgeschriebenen Richtung oder verbotswidrig befahren.

Die letztgenannten Aufgaben werden zurzeit mit Hilfe von Induktionsschleifen bewältigt, die zur Steuerung von Ampeln, Schranken in Ein- und Ausfahrten von Parkplätzen oder punktuell zur Geschwindigkeits- und Abstandskontrolle auf Autobahnen verwendet werden. Nachteilig an diesen bekannten Lösungen ist aber, dass sie sehr aufwendig und kostspielig sind.

Gleiches gilt für eine Bildverarbeitung von Videosignalen, wobei diese Systeme überdies witterungsabhängig und z.B. bei Regen, Nebel oder Schneefall nur bedingt funktionsfähig sind.

Ultraschallsensoren werden häufig in Parkhäusern eingesetzt, um die Belegung eines Parkplatzes festzustellen. Für einen Einsatz im Freien ist eine solche Sensorik aber nicht geeignet.

Einzelne Magnetfeldsensoren zur punktuellen Überwachung von Parkflächen, Zufahrten usw. sind bereits auf dem Markt, doch sind diese Sensoren einzeln verlegt und jeder arbeitet für sich autark. Dies hat den Nachteil, dass speziell beim Einsatz im Boden die Dichtigkeit der Sensorgehäuse im Bezug auf die Verkabelung bei starken Temperaturschwankungen Probleme bereiten.

Demgegenüber kann das Kabel einer erfindungsgemäßen Messanordnung auf einfache Weise im Freien oder aber auch in Gebäuden in den Boden eingebracht werden. Es vereinigt somit die Vorteile der bisherigen Techniken ohne deren Nachteile zu besitzen.

Die Erfindung wird im Folgenden anhand eines Ausführungsbeispiels unter Bezugnahme auf die Zeichnung beschrieben; in dieser zeigen:
- Fig. 1: eine schematische Darstellung einer erfindungsgemäßen Messanordnung;
- Fig. 2: einen Schnitt durch eine erste Ausführungsform eines Kabels für eine erfindungsgemäße Messanordnung; und
- Fig. 3: einen Schnitt durch eine zweite Ausführungsform eines Kabels für eine erfindungsgemäße Messanordnung.

In den Figuren sind gleiche Teile mit denselben Bezugszeichen bezeichnet.

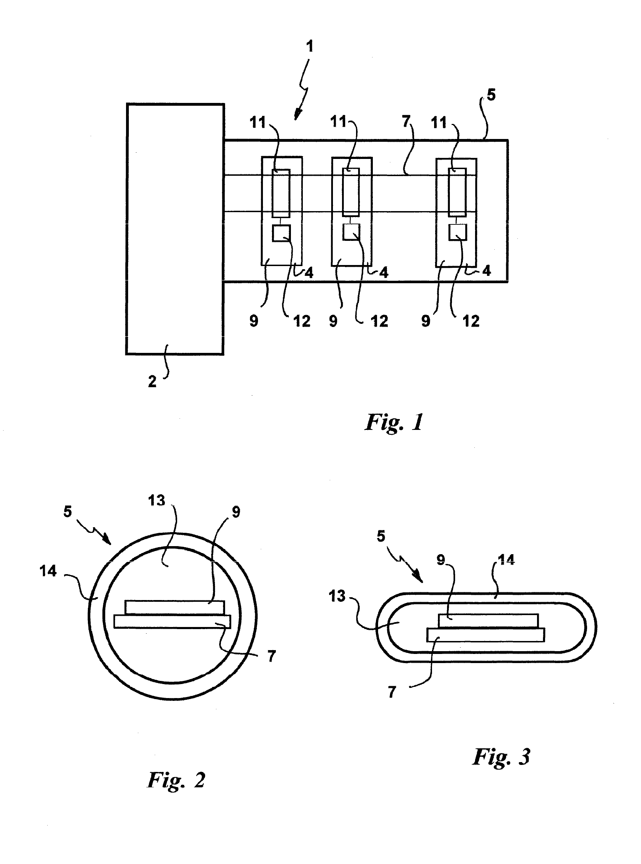

Fig. 1 zeigt in stark schematisierter Weise eine erfindungsgemäße Messanordnung 1 mit einer Zentrale 3, von der aus sich ein der Deutlichkeit halber nur sehr kurz dargestelltes, in Wirklichkeit aber langes Kabel 5 erstreckt, in dessen Inneren in Längsrichtung eine Busleitung 7 verläuft.

Die Busleitung 7 verbindet eine Vielzahl von Messeinheiten 4 miteinander und mit der Zentrale 3. Jede Messeinheit 4 umfasst einen Träger 9, der auf der Busleitung 7 montiert ist und jeweils jeder Mikroprozessor 11 und einen mit diesem verbundenen Magnetfeldsensor 12 trägt. Diese Träger können beispielsweise ein gedrucktes Schaltungsplatinenplättchen, ein Keramikplättchen oder eine Folie sein.

Zwar sind in Fig. 1 nur drei Messeinheiten 4 dargestellt, doch kann das Kabel 5 in der Praxis mehrere hundert Meter lang sein und es kann in seinem Inneren mehrere hundert Messeinheiten 4 mit einer entsprechenden Anzahl von Mikroprozessoren und Magnetfeldsensoren umfassen.

Wesentlich ist, dass das Kabel hermetisch dicht aufgebaut ist, so dass es die in ihm enthaltenen Komponenten auch dann sicher gegen Umwelteinflüsse schützt, wenn es im Freien beispielsweise auf oder in der Fahrbahn einer Straße oder eines Parkplatzes verlegt ist.

In Fig. 2 ist ein Kabel 5 mit in etwa kreisförmigem Querschnitt dargestellt, in dessen Inneren wieder die mehradrige Busleitung 7 und ein auf ihr montierter Träger 9 zu sehen sind, der einen hier nicht dargestellten Mikroprozessor und zugehörigen Magnetfeldsensor trägt.

Der Innenraum des Kabels ist mit einem Füllmaterial 13 ausgefüllt, das die Busleitung 7 und die auf ihr montierten Träger 9 vollständig umgibt und dise gemeinsam mit dem Mantel 14 des Kabels 5 gegen Umwelteinflüsse schützt.

Fig. 3 zeigt eine Ausführungsform eines erfindungsgemäßen Kabels 5, das den gleichen prinzipiellen Aufbau wie das Kabel aus Fig. 2 besitzt und sich von diesem nur dadurch unterscheidet, dass es einen flachen, nur an den Seitenkanten abgerundeten Querschnitt aufweist.

## Patentansprüche

1. Messanordnung (1) mit einer Vielzahl von Messeinheiten (4), die durch ein Kabel (5) miteinander und mit einer Zentrale (2) verbunden sind und jeweils wenigstens einen Magnetfeldsensor (12) umfassen, der ein elektrisches Messsignal erzeugt, das seinen Wert in Abhängigkeit von einem in der Umgebung des Magnetfeldsensors (12) herrschenden Magnetfeld ändert, wobei die Messeinheiten (4) von der Zentrale (2) mit elektrischer Energie versorgt werden und jeweils eine Adresse besitzen, sodass die Zentrale (2) zyklisch die von den Magnetfeldsensoren (12) erzeugten, momentanen Messwerte einzeln nacheinander abfragen und einer Auswerte- und Speichereinheit für eine Weiterverarbeitung zuführen kann,
**dadurch gekennzeichnet, dass**
- jeder der Magnetfeldsensoren (12) auf einem von dem Kabel (5) vollständig und dicht umschlossenen Träger (9) montiert ist,
- dass die Träger (9) mit gegenseitigen Abständen auf einer im Inneren des Kabels (5) verlaufenden, zur Zentrale (2) führenden, mehradrigen, keine Unterbrechungen aufweisenden Busleitung (7) montiert sind, die zur Energieversorgung der Messeinheiten (4) und zur Datenübermittlung dient, und
- dass jede der Messeinheiten (4) einen eigenen Mikroprozessor (11) mit Speichereinheit umfasst, der mit dem zugehörigen Magnetfeldsensor (12) verbunden und so ausgebildet ist, dass er zumindest eine Vorverarbeitung des vom Magnetfeldsensor (12) erzeugten Messsignals ausführen kann.

2. Messanordnung (1) nach Anspruch 1, **dadurch gekennzeichnet, dass** jeder der Mikroprozessoren (11) auf dem gleichen Träger (9) wie der zugehörige Magnetfeldsensor (12) montiert ist und mit der Busleitung (7) in Verbindung steht.

3. Messanordnung (1) nach Anspruch 1 oder 2, **dadurch gekennzeichnet, dass** die Taktfrequenz, mit der die Mikroprozessoren (11) arbeiten, von der Taktfrequenz verschieden ist, mit der die Daten auf der Busleitung (7) übertragen werden.

4. Messanordnung (1) nach einem der vorhergehenden Ansprüche, **dadurch gekennzeichnet, dass** die Magnetfeldsensoren (12) Änderungen des Erdmagnetfeldes erkennen und dass das Kabel (5) zu Erfassung der momentanen Position von Körpern, die sich auf einer Oberfläche bewegen können und eine ferromagnetische, das Erdmagnetfeld beeinflussende Masse umfassen, auf oder knapp unter dieser Oberfläche verlegt ist.

5. Messanordnung (1) nach Anspruch 4, **dadurch gekennzeichnet, dass** es sich bei den Körpern, deren momentane Position erfasst werden soll, um Fahrzeuge handelt.

6. Messanordnung (1) nach Anspruch 5, **dadurch gekennzeichnet, dass** die Fahrzeuge Straßenfahrzeuge sind.

7. Messanordnung (1) nach Anspruch 6, **dadurch gekennzeichnet, dass** das die Magnetfeldsensoren (12) enthaltende Kabel (5) zur Parkplatzüberwachung im Bereich der Stellplätze auf oder unter der Fahrbahndecke verlegt ist.

8. Messanordnung (1) nach Anspruch 7, **dadurch gekennzeichnet, dass** das Kabel (5) so verlegt ist, dass sich im Bereich eines jeden Stellplatzes mehrere Magnetfeldsensoren (12) befinden.

9. Messanordnung (1) nach Anspruch 6, **dadurch gekennzeichnet, dass** das Kabel (5) unter der Fahrbahndecke einer Strasse verlegt ist.

10. Messanordnung (1) nach Anspruch 9, dass die Messsignale der Magnetfeldsensoren (12) zur Geschwindigkeitsmessung von Fahrzeugen verwendet werden und dass die zur hierzu erforderlichen Zeitmessungen zwischen von einem Magnetfeldsensor (12) erfassten Magnetfeldänderungen von dem Mikroprozessor (11) durchgeführt werden, der sich in der Messeinheit (4) des betreffenden Magnetfeldsensors (12) befindet, und dass die Ergebnisse dieser Zeitmessungen über die Busleitung (7) an die Zentrale (2) weitergeleitet werden.

11. Messanordnung nach Anspruch 9 oder 10 , **dadurch gekennzeichnet, dass** die Messsignale der Magnetfeldsensoren (12) zur Ermittlung der Verkehrsdicht verwendet werden.
